(19) Europäisches Patentamt
European Patent Office
Office européen des brevets

(11) **EP 3 662 579 B1**

(12) **EUROPÄISCHE PATENTSCHRIFT**

(45) Veröffentlichungstag und Bekanntmachung des Hinweises auf die Patenterteilung:
**20.07.2022 Patentblatt 2022/29**

(21) Anmeldenummer: **18752713.0**

(22) Anmeldetag: **02.08.2018**

(51) Internationale Patentklassifikation (IPC):
**H03K 17/12** *(2006.01)*    **H03K 17/14** *(2006.01)*
**H03K 17/16** *(2006.01)*

(52) Gemeinsame Patentklassifikation (CPC):
**H03K 17/122; H03K 17/165**

(86) Internationale Anmeldenummer:
**PCT/EP2018/071042**

(87) Internationale Veröffentlichungsnummer:
**WO 2019/025563 (07.02.2019 Gazette 2019/06)**

(54) **VORRICHTUNG UND VERFAHREN ZUR HOMOGENEN STROMVERTEILUNG UND/ODER ZUR REDUZIERUNG VON SCHALTVERLUSTEN VON ELEKTRISCH STEUERBAREN SCHALTELEMENTEN**

DEVICE AND METHOD FOR HOMOGENEOUSLY DISTRIBUTING CURRENT AND/OR FOR REDUCING SWITCHING LOSSES OF ELECTRICALLY CONTROLLABLE SWITCHING ELEMENTS

DISPOSITIF ET PROCÉDÉ DE DISTRIBUTION HOMOGÈNE DE COURANT ET/OU DE RÉDUCTION DE PERTES DE COMMUTATION D'ÉLÉMENTS DE COMMUTATION COMMANDABLES ÉLECTRIQUEMENT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **02.08.2017 DE 102017117566**

(43) Veröffentlichungstag der Anmeldung:
**10.06.2020 Patentblatt 2020/24**

(73) Patentinhaber: **Technische Universität Dortmund 44227 Dortmund (DE)**

(72) Erfinder:
• **EBLI, Michael**
**44263 Dortmund (DE)**
• **PFOST, Martin**
**72762 Reutlingen (DE)**

(74) Vertreter: **Michalski Hüttermann & Partner Patentanwälte mbB**
**Kaistraße 16A**
**40221 Düsseldorf (DE)**

(56) Entgegenhaltungen:
**CA-A1- 2 986 883    US-A1- 2016 352 330**

## Beschreibung

Die vorliegende Erfindung betrifft eine Vorrichtung und ein Verfahren zur homogenen Stromverteilung und/oder zur Reduzierung von Schaltverlusten von elektrisch steuerbaren Schaltelementen.

Um die Stromtragfähigkeit von Leistungsmodulen zu erhöhen, können Transistoren parallel geschaltet werden. Ein bekanntes Problem von parallel geschalteten Transistoren ist die ungleichmäßige Stromverteilung während des Schaltens. Herkömmliche Ansätze versuchen eine gleichmäßige Stromverteilung während des Schaltens des Transistors durch eine symmetrische Anordnung der einzelnen Halbleiter Chips zu erreichen. Nachteilig ist hier, dass Bauteilstreuungen, wie beispielsweise unterschiedliche Schwellspannungen ($V_{th}$) oder Steilheit $\left(\frac{\partial i_S}{\partial V_{GS}}\right)$ der einzelnen Halbleiter Chips, nicht ausgeglichen werden können. Weitere Ansätze versuchen dies durch einen aktiven Eingriff in den Gate Treiber auszugleichen. Hierbei ist für die Strommessung und deren Auswertung zusätzlicher Schaltungsaufwand notwendig. Weiterhin ist eine sehr genaue zeitliche Auflösung erforderlich, wobei ein weiterer Nachteil die Kalibrierung des Systems ist. Hierbei müssen die einzelnen Zeitverzögerungen ausgemessen werden und in die Steuerung einprogrammiert werden. Einflüsse über die Lebenszeit des Moduls werden nicht erfasst. Für die Parallelschaltung von Leistungstransistoren sind unter anderem der Einschaltwiderstand, die unterschiedlichen Schwellspannungen ($V_{th}$) und die unterschiedlichen Transfer Charakteristika (Steilheit) der einzelnen Chips entscheidend. Insbesondere die unterschiedlichen Schwellspannungen ($V_{th}$) und die unterschiedlichen Transfer Charakteristika (Steilheit) haben großen Einfluss auf das Schaltverhalten der Transistoren.

Die US 2016/0352330 A1 beschreibt eine Schaltung, die einen ersten Schaltkreis parallel zu einem zweiten Schaltkreis enthält. Der erste Schaltkreis-Schalter und der zweite Schaltkreis-Schalter sind über Verbindungen mit einem ersten Treiberknoten, einem zweiten Treiberknoten, einem Source-Knoten und einem Drain-Knoten verbunden.

Die CA 2 986 883 A1 beschreibt eine Leistungsumwandlungsvorrichtung, die mit einer Gatespannungs-Einstelleinrichtung versehen ist. Die Leistungsumwandlungsvorrichtung wirkt auf das Treibersignal von einer Gate-Treiberschaltung ein und sendet ein Treibersignal an die Gates mehrerer parallel angeordneter Halbleiterelemente. Die Leistungsumwandlungsvorrichtung stellt die Gatespannungen der Halbleiterelemente ein.

Es ist daher die Aufgabe der vorliegenden Erfindung, eine Vorrichtung und ein Verfahren für elektrisch gesteuerte Schaltelemente bereitzustellen, die es ermöglichen, eine gleichmäßigere Stromverteilung während des Schaltens zu erzielen und/oder die Schaltenergie zu reduzieren.

Diese Aufgabe wird durch die Gegenstände der nebengeordneten Ansprüche gelöst. Vorteilhafte Ausführungsformen sind Gegenstand der Unteransprüche.

Sofern nichts anderes angegeben ist, wird im Rahmen der vorliegenden Beschreibung unter dem Begriff "Verbinden" stets ein elektrisches Verbinden verstanden.

Ein erster unabhängiger Aspekt zur Lösung der Aufgabe betrifft eine Schaltungsvorrichtung aufweisend: eine Mehrzahl von elektrisch gesteuerten Schaltelementen, wobei die Mehrzahl von elektrisch gesteuerten Schaltelementen parallel zueinander geschaltet sind und über einen gemeinsamen Steuereinheit-Steueranschluss Pfad miteinander verschaltet sind, eine Steuereinheit zum Bereitstellen eines Steuersignals, wobei jedes der elektrisch gesteuerten Schaltelemente aufweist: einen ersten Laststromanschluss für den Zufluss eines zu schaltenden Laststroms, einen zweiten Laststromanschluss für den Abfluss des zu schaltenden Laststroms und einen Steueranschluss zum Steuern des Schaltelements mittels des Steuersignals, wobei der erste und der zweite Laststromanschluss in einem Laststrompfad der Schaltungsvorrichtung integriert sind und wobei der Steueranschluss in einem Steuerstrompfad der Schaltungsvorrichtung integriert ist, ein Kopplungselement zum galvanisch getrennten Übertragen von Energie, wobei ein erster Teil des Kopplungselements, wenigstens zwei Anschlüsse aufweist und in Serie mit dem Laststrompfad verschaltet ist, und ein zweiter Teil des Kopplungselements wenigstens zwei Anschlüsse aufweist, wobei zumindest einer der Anschlüsse mit dem gemeinsamen Steuereinheit-Steueranschluss Pfad verbunden ist. Erfindungsgemäß ist ein weiterer Anschluss des zweiten Teils des Kopplungselements mit dem Steueranschluss des jeweiligen elektrisch gesteuerten Schaltelements verbunden, wobei jedes der elektrisch gesteuerten Schaltelemente ein weiteres Kopplungselement aufweist, wobei die zweiten Teile der Kopplungselemente der weiteren Kopplungselemente der elektrisch gesteuerten Schaltelemente in Serie verschaltet sind, wobei die Serienschaltung der zweiten Teile der Kopplungselemente der weiteren Kopplungselemente in Serie mit dem gemeinsamen Steuereinheit-Steueranschluss Pfad verschaltet ist.

Das Kopplungselement limitiert oder erhöht die Stromänderung während des Schaltens des Schaltelements. Die Stromänderung ruft eine Spannung proportional zur Stromänderung hervor, wobei die Spannung in den Steuerstrompfad wieder eingekoppelt wird und zu einer Abbremsung oder Beschleunigung der Schaltgeschwindigkeit führt. Durch diese Maßnahme wird ein gleichmäßiger Stromanstieg der einzelnen Stränge erreicht. Ein Nachteil dabei ist die erhöhte Verlustleistung. Dies wird durch das Koppeln bzw. Übertragen von Energie aus dem Laststrompfad in den gemeinsamen Steuereinheit-Steueranschluss Pfad kompensiert. Das zweite Kopplungselement stellt eine zweite unabhängige Spannung zur Verfügung, welche wiederum proportional zur Stromänderung ist. Die Spannungen der einzelnen Kopplungselemente werden in Reihe geschaltet und in den gemeinsamen Steuereinheit-Steueranschluss Pfad der Schaltelemente eingespeist. Eine negative Spannung erhöht die Schaltgeschwindigkeit des gesamten Moduls. Durch die Rückkopplung durch die Kopplungselemente kann die Stromänderung insgesamt erhöht werden, wodurch die Schaltverluste reduziert werden. Die einzelnen Pfade werden durch selektive Abbremsung, mithilfe der ersten Kopplungselemente, auf einen gleichen Stromänderungswert getrimmt.

Unter einer "Schaltungsvorrichtung" wird im Sinne der Erfindung eine elektrische Schaltung bzw. ein elektrischer Schaltkreis verstanden. Unter einem "elektrisch gesteuerten Schaltelement" wird ein elektrischer Schalter, insbesondere ein Halbleiterschalter bzw. ein Transistor, verstanden, welcher über eine Ladung oder einen Strom gesteuert, d.h. ein- und ausgeschaltet werden kann. Das Schaltelement kann also elektrisch, d.h. insbesondere mit Hilfe einer Spannung oder eines Stroms gesteuert bzw. geschaltet werden. Das elektrisch gesteuerte Schaltelement kann daher z.B. ein spannungsgesteuertes oder stromgesteuertes Schaltelement sein.

Die parallel geschalteten, elektrisch gesteuerten Schaltelemente können z.B. Halbleiter bzw. Halbleiterschalter und insbesondere Transistoren sein. Grundsätzlich kann das elektrisch gesteuerte Schaltelement jegliche Art eines elektrisch gesteuerten Schalters bzw. Transistors darstellen. Beispielsweise kann das Schaltelement ein Bipolartransistor oder ein Feldeffekt-Transistor (FET) sein. Das elektrisch gesteuerte Schaltelement kann insbesondere ein Bipolartransistor mit isolierter Gate-Elektrode (IGBT) oder ein High-electron-mobility transistor (HEMT) sein, um nur zwei willkürlich gewählte Beispiele zu nennen. Insbesondere handelt es sich bei dem elektrisch gesteuerten Schaltelement um einen Leistungsschalter bzw. Leistungstransistor bzw. Leistungshalbleiter.

Das elektrisch gesteuerte Schaltelement weist zumindest drei verschiedene Anschlüsse auf, nämlich einen ersten und zweiten Laststromanschluss sowie einen Steueranschluss. Allgemein wird unter dem Begriff "Anschluss" eine Elektrode des Schaltelements verstanden. An die Laststromanschlüsse kann ein Verbraucher oder eine Last angeschlossen werden, welcher/welche über das Schaltelement gesteuert bzw. geschaltet werden kann. Über den Steueranschluss kann ein Laststrom, welcher durch den Schalter bzw. durch einen Verbraucher fließt, geregelt bzw. elektrisch gesteuert werden. Dabei umfasst der Begriff "Steuern" insbesondere ein Ein- und Ausschalten bzw. ein Aktivieren und Deaktivieren. Mit anderen Worten kann das Schaltelement z. B. durch Aufbringen einer bestimmten Ladung bzw. durch Anlegen einer bestimmten Spannung an den Steueranschluss des Schaltelements elektrisch leitend oder isolierend geschaltet werden.

Im Falle eines Bipolartransistors kann der erste Laststromanschluss z.B. ein Emitter oder Kollektor sein. Im Fall eines Feldeffekt-Transistors kann dieser erste Laststromanschluss z.B. ein Source- oder Drain-Anschluss sein. Der zweite Laststromanschluss des elektrisch gesteuerten Schaltelements kann im Fall eines Bipolartransistors entsprechend ein Kollektor oder Emitter und im Fall eines Feldeffekt-Transistors entsprechend ein Drain- oder Source-Anschluss sein. Beispielsweise ist der erste Laststromanschluss ein Drain-Anschluss und der zweite Laststromanschluss ein Source-Anschluss. Weiter beispielsweise ist der erste Laststromanschluss ein Emitter und der zweite Laststromanschluss ein Kollektor. Der Steueranschluss kann z. B. im Fall eines Bipolartransistors ein Basis-Anschluss und im Fall eines Feldeffekt-Transistors ein Gate-Anschluss sein. Insbesondere ist bei Leistungsschalter bzw. Leistungs-FET der Source-Anschluss mit einem Bulk Anschluss verbunden.

Der erste und der zweite Laststromanschluss sind in einem Laststrompfad bzw. Laststromkreis der Schaltungsvorrichtung integriert. Mit anderen Worten sind der erste und der zweite Laststromanschluss Bestandteile eines Laststrompfades. Insbesondere sind der erste und der zweite Laststromanschluss mit dem Laststrompfad verbunden. Durch den Laststrompfad bzw. im Laststromkreis fließt im leitenden Zustand des Schaltelements ein Laststrom. Beispielsweise kann der Laststrompfad bzw. der Laststromkreis eine Lastkreis-Spannungsquelle, eine Last sowie den ersten und zweiten Laststromanschluss umfassen. Insbesondere kann der Laststrompfad bzw. der Laststromkreis als ein Strompfad bzw. Stromkreis ausgebildet sein, der eine Lastkreis-Spannungsquelle, eine Last sowie den ersten und zweiten Laststromanschluss des Schaltelements miteinander verbindet. Mit anderen Worten kann der Laststrompfad eine elektrische Verbindung bzw. Verdrahtung einer Lastkreis-Spannungsquelle mit einer Last und dem ersten und zweiten Laststromanschluss des Schaltelementes umfassen bzw. dadurch ausgebildet sein. Insbesondere ist die Lastkreis-Spannungsquelle mit dem ersten Laststromanschluss und die Last mit dem zweiten Laststromanschluss verbunden.

Der Steueranschluss ist in einem Steuerstrompfad bzw. Steuerstromkreis oder Gatestromkreis der Schaltungsvorrichtung integriert. Mit anderen Worten ist der Steueranschluss ein Bestandteil des Steuerstrompfades. Insbesondere ist der Steueranschluss mit dem Steuerstrompfad verbunden. Der Steuerstrompfad bzw. Steuerkreis dient zum Steuern des Schaltelements. Beispielsweise kann der Steuerstrompfad bzw. der Steuerstromkreis die Steuereinheit bzw. einen Gate-Treiber und den Steueranschluss des Schaltelements umfassen. Mit anderen Worten kann der Steuerstrompfad eine elektrische Verbindung bzw. Verdrahtung der Steuereinheit mit dem Steueranschluss des Schaltelementes umfassen bzw. dadurch ausgebildet sein. Insbesondere ist die Steuereinheit mit dem Steueranschluss des Schaltelements verbunden. Die Steuereinheit kann zumindest eine schaltbare Steuer-Spannungsquelle oder Steuer-Stromquelle zum Bereitstellen einer Steuerspannung oder Steuerstroms umfassen. Insbesondere kann die Steuereinheit zumindest eine Spannungsquelle oder Stromquelle und einen oder mehrere Steuerschalter umfassen. Vorzugsweise umfasst die Steuereinheit einen Standard Gate-Treiber. Die Steuereinheit der Schaltungsvorrichtung stellt das Steuersignal bereit. Mit Hilfe der Steuereinheit kann das Schaltelement gesteuert, d. h. ein und ausgeschaltet bzw. leitend und isolierend geschaltet werden. Die Steuereinheit ermöglicht insbesondere ein statisches Einschalten des Schaltelements.

Ferner weist jedes der elektrisch gesteuerten Schaltelemente der Schaltungsvorrichtung ein Kopplungselement zum galvanisch getrennten Übertragen von Energie bzw. einer Ladung, einer Spannung und/oder eines Stroms auf. Das Kopplungselement kann insbesondere ein induktives, kapazitives oder optisches Kopplungselement sein. Mit anderen Worten kann die Kopplung bzw. Rückkopplung von Energie induktiv, kapazitiv oder optisch erfolgen. Unter einer galvanischen Trennung oder galvanischen Entkopplung wird allgemein das Vermeiden von elektrischen Leitungen zwischen zwei Strompfaden bzw. Stromkreisen, zwischen denen Leistung oder Signale ausgetauscht werden sollen, verstanden. Anstelle einer elektrischen Leitung wird das Kopplungselement verwendet.

Zur Erhöhung der Stromtragfähigkeit von Leistungsmodulen werden die Transistoren parallel geschaltet, wobei jeder der Transistoren einen einzelnen Strang repräsentiert. Die parallel geschalteten Transistoren besitzen dabei einen gemeinsamen Steuereinheit-Steueranschluss Pfad.

Gemäß der Erfindung ist ein weiterer Anschluss des zweiten Teils des Kopplungselements mit dem Steueranschluss des jeweiligen elektrisch gesteuerten Schaltelements verbunden. Durch die induktive Kopplung vom Last- zum Gatekreis durch das Kopplungselement wird eine gezielte Reduzierung oder Erhöhung der Stromänderung ermöglicht. Vorteilhaft dabei ist, dass dadurch ein als elektrisch gesteuertes Schaltelement verwendeter Transistor beschleunigt oder ausgebremst wird.

In einer weiter bevorzugten Ausführungsform der Erfindung ist zumindest einer der Anschlüsse des zweiten Teils des Kopplungselements eines ersten elektrisch gesteuerten Schaltelements mit dem Steueranschluss eines weiteren elektrisch gesteuerten Schaltelements verbunden, wobei zumindest ein weiterer Anschluss des zweiten Teils des Kopplungselements des ersten elektrisch gesteuerten Schaltelements mit dem gemeinsamen Steuereinheit-Steueranschluss Pfad verbunden ist, wobei zumindest einer der Anschlüsse des zweiten Teils des Kopplungselements des weiteren elektrisch gesteuerten Schaltelements mit dem Steueranschluss des ersten elektrisch gesteuerten Schaltelements verbunden ist und wobei zumindest ein weiterer Anschluss des zweiten Teils des Kopplungselements des weiteren elektrisch gesteuerten Schaltelements mit dem gemeinsamen Steuereinheit-Steueranschluss Pfad verbunden ist. Ein als elektrisch gesteuertes Schaltelement verwendeter Transistor wird durch die Stromänderung des benachbarten Transistors beschleunigt oder ausgebremst.

Erfindungsgemäß sind die zweiten Teile der Kopplungselemente der elektrisch gesteuerten Schaltelemente in Serie verschaltet, wobei die Serienschaltung der zweiten Teile der Kopplungselemente in Serie mit dem gemeinsamen Steuereinheit-Steueranschluss Pfad verschaltet ist. Durch die Serienschaltung der zweiten Teile der Kopplungselemente können alle elektrisch gesteuerten Schaltelemente global beschleunigt oder ausgebremst werden.

In einer bevorzugten Ausführungsform der Erfindung ist das Kopplungselement ein Transformator, wobei der erste Teil des Kopplungselements eine Primärspule des Transformators ist und der zweite Teil des Kopplungselements eine Sekundärspule des Transformators ist.

In einer weiteren bevorzugten Ausführungsform der Erfindung weist die Steuereinheit zumindest eine Spannungsquelle und/oder einen Standard Gate Treiber auf. Die Spannungsquelle dient insbesondere zum Bereitstellen einer Steuerspannung für den Steueranschluss des Schaltelements und kann somit auch als Steuer-Spannungsquelle bezeichnet werden. Alternativ oder zusätzlich umfasst die Schaltungsvorrichtung einen Standard Gate-Treiber. Die Spannungsquelle oder Stromquelle und/oder der Standard Gate-Treiber sind vorzugsweise über die Sekundärspule des Transformators mit dem Steueranschluss des Schaltelements verbunden. Die Spannungsquelle oder Stromquelle ist insbesondere ein Bestandteil des Gate-Treibers. Mit Hilfe der Steuereinheit können die parallel geschalteten Schaltelemente gesteuert werden, d.h. ein und ausgeschaltet bzw. leitend und isolierend geschaltet werden. Die Steuereinheit ermöglicht insbesondere ein statisches Einschalten des Leistungsmoduls. Der Verbraucher bzw. die Last kann dabei über die gemeinsame Steuereinheit ein- und ausgeschaltet werden.

Ein weiterer unabhängiger Aspekt zur Lösung der Aufgabe betrifft ein Verfahren zur homogenen Stromverteilung und/oder zur Reduzierung von Schaltverlusten für parallel geschaltete, elektrisch gesteuerte Schaltelemente aufweisend:

- Bereitstellen von parallel geschalteten, elektrisch gesteuerten Schaltelementen wobei jedes der elektrisch gesteuerten Schaltelemente aufweist: einen ersten Laststromanschluss für den Zufluss eines zu schaltenden Laststroms, einem zweiten Laststromanschluss für den Abfluss des zu schaltenden Laststroms und einem Steueranschluss zum Steuern des Schaltelements, wobei der erste und der zweite Laststromanschluss in einen Laststrompfad und der Steueranschluss in einen Steuerstrompfad integriert wird;

- Steuern der parallel geschalteten, elektrisch gesteuerten Schaltelemente mit Hilfe einer Steuereinheit über einen gemeinsamen Steuereinheit-Steueranschluss Pfad;

- galvanisch getrenntes Übertragen von Energie mit Hilfe eines Kopplungselements, wobei ein erster Teil des Kopplungselements, wenigstens zwei Anschlüsse aufweist und in Serie mit dem Laststrompfad verschaltet ist, und ein zweiter Teil des Kopplungselements wenigstens zwei Anschlüsse aufweist, wobei zumindest einer der Anschlüsse mit dem gemeinsamen Steuereinheit-Steueranschluss Pfad verbunden ist

- galvanisch getrenntes Übertragen von Energie mit Hilfe der Kopplungselemente aus den Laststrompfaden in die Steuerstrompfade des jeweiligen elektrisch gesteuerten Schaltelements, wobei zumindest ein weiterer Anschluss des zweiten Teils des Kopplungselements mit dem Steueranschluss des jeweiligen elektrisch gesteuerten Schaltelements verbunden ist, wobei jedes der elektrisch gesteuerten Schaltelemente ein weiteres Kopplungselement aufweist;

- galvanisch getrenntes Übertragen von Energie mit Hilfe der weiteren Kopplungselemente aus den Laststrompfaden der elektrisch gesteuerten Schaltelemente in den gemeinsamen Steuereinheit-Steueranschluss Pfad, wobei die zweiten Teile der Kopplungselemente der weiteren Kopplungselemente der elektrisch gesteuerten Schaltelemente in Serie verschaltet sind, wobei die Serienschaltung der zweiten Teile der Kopplungselemente der weiteren Kopplungselemente in Serie mit dem gemeinsamen Steuereinheit-Steueranschluss Pfad verschaltet ist.

In einer weiteren bevorzugten Ausführungsform des Verfahrens ist zumindest einer der Anschlüsse des zweiten Teils des Kopplungselements eines ersten elektrisch gesteuerten Schaltelements mit dem Steueranschluss eines weiteren elektrisch gesteuerten Schaltelements verbunden, wobei zumindest ein weiterer Anschluss des zweiten Teils des Kopplungselements des ersten elektrisch gesteuerten Schaltelements mit dem gemeinsamen Steuereinheit-Steueranschluss Pfad verbunden ist, wobei zumindest einer der Anschlüsse des zweiten Teils des Kopplungselements des weiteren elektrisch gesteuerten Schaltelements mit dem Steueranschluss des ersten elektrisch gesteuerten Schaltelements verbunden ist, wobei zumindest ein weiterer Anschluss des zweiten Teils des Kopplungselements des weiteren elektrisch gesteuerten Schaltelements mit dem gemeinsamen Steuereinheit-Steueranschluss Pfad verbunden ist, wobei das Verfahren weiter aufweist:

- galvanisch getrenntes Übertragen von Energie mit Hilfe eines Kopplungselements aus dem Laststrompfad des ersten elektrisch gesteuerten Schaltelements in den Steuerstrompfad des weiteren elektrisch gesteuerten Schaltelements,

- galvanisch getrenntes Übertragen von Energie mit Hilfe eines Kopplungselements aus dem Laststrompfad des weiteren elektrisch gesteuerten Schaltelements in den Steuerstrompfad des ersten elektrisch gesteuerten Schaltelements.

Erfindungsgemäß sind bei dem Verfahren die zweiten Teile der Kopplungselemente der elektrisch gesteuerten Schaltelemente in Serie verschaltet, wobei die Serienschaltung der zweiten Teile der Kopplungselemente in Serie mit dem gemeinsamen Steuereinheit-Steueranschluss Pfad verschaltet ist, wobei das Verfahren weiter aufweist:

- galvanisch getrenntes Übertragen von Energie mit Hilfe der Kopplungselemente aus den Laststrompfaden der elektrisch gesteuerten Schaltelemente in den gemeinsamen Steuereinheit-Steueranschluss Pfad.

Die Erfindung wird nachfolgend anhand von Figuren weiter erläutert.

Es zeigen:

Fig. 1 ein schematisches Schaltbild einer beispielhaften Schaltungsvorrichtung ;

Fig. 2 ein weiteres schematisches Schaltbild einer anderen beispielhaften Schaltungsvorrichtung;

Fig. 3 ein weiteres schematisches Schaltbild einer weiteren beispielhaften Schaltungsvorrichtung;

Fig. 4 ein schematisches Schaltbild einer Schaltungsvorrichtung gemäß einer Ausführungsform der vorliegenden Erfindung;

Fig. 5 ein weiteres schematisches Schaltbild einer Schaltungsvorrichtung gemäß einer bevorzugten Ausführungsform der vorliegenden Erfindung;

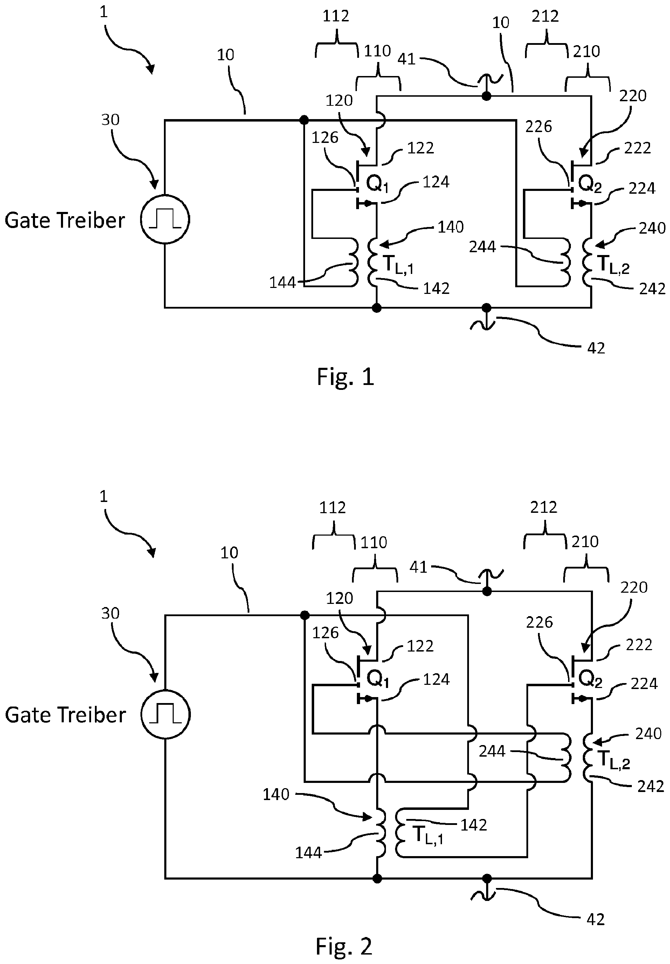

Die Fig. 1 zeigt ein schematisches Schaltbild einer beispielhaften Schaltvorrichtung.

Die Schaltungsvorrichtung 1 umfasst zwei parallel geschaltete, elektrisch gesteuerte Schaltelemente 120, 220 mit zwei Kopplungselementen 140, 240 und einer Steuereinheit 30. Die elektrisch gesteuerten Schaltelemente 120, 220 sind beispielsweise Halbleiterbauelemente bzw. Transistoren. Die Schaltelemente 120, 220 weisen einen ersten Laststromanschluss 122, 222 für den Zufluss eines zu schaltenden Laststroms und einen zweiten Laststromanschluss 124, 224 für den Abfluss des zu schaltenden Laststroms auf. Zudem weisen die Schaltelemente 120, 220 einen Steueranschluss 126, 226 zum Steuern der Schaltelemente mittels eines Steuersignals auf. Bei den Laststromanschlüssen 122, 222; 124, 224 handelt es sich insbesondere um die Drain- und Source-Anschlüsse eines Transistors. Bei dem Steueranschluss 126, 226 handelt es sich insbesondere um den Gate-Anschluss eines Transistors. Die Transistoren werden mittels eines Steuersignals geschaltet, das über einen gemeinsamen Steuereinheit-Steueranschluss Pfad 10 übertragen wird. Die Schaltvorrichtung 1 umfasst bzw. ist unterteilt in Laststrompfade bzw. Laststromkreise 110, 210 und Steuerstrompfade bzw. Steuerstromkreise 112, 212. Die ersten und die zweiten Laststromanschlüsse 122, 222; 124, 224 der Schaltelemente 120, 220 sind in die Laststrompfade 110, 210 integriert, während die Steueranschlüsse 126, 226 der Schaltelemente 120, 220 in die Steuerstrompfade 112, 212 integriert sind. In den Laststrompfaden 110, 210 fließen Lastströme, welcher mit Hilfe der Schaltelemente bzw. mit Hilfe der Steuerstrompfade 112, 212 gesteuert werden können. Über die parallel geschalteten Laststrompfade 110, 210 kann ein Verbraucher bzw. eine Last integriert sein, die über die beiden Lastanschlüsse 41, 42 mit den Laststrompfaden 110, 210 verbunden ist. Der Verbraucher bzw. die Last kann über die gemeinsame Steuereinheit ein- und ausgeschaltet werden. Bei den Kopplungselementen 140, 240 handelt es sich um Transformatoren mit einer Primärspule 142, 242 und einer Sekundärspule 144, 244. Die Primärspule 142, 242 und die Sekundärspule 144, 244 sind induktiv miteinander gekoppelt. Die Primärspulen 142, 242 der Kopplungselemente sind in den Laststrompfad der Transistoren integriert, wobei die Sekundärspulen 144, 244 mit einem ihrer Anschlüsse mit dem gemeinsamen Steuereinheit-Steueranschluss Pfad 10 verbunden ist. Der weitere Anschluss der Sekundärspule 144, 244 ist mit dem Steueranschluss 126, 226 des jeweiligen Transistors verbunden.

Die Fig. 2 zeigt ein schematisches Schaltbild einer Schaltungsvorrichtung gemäß einer anderen beispielhaften Schaltvorrichtung.

Bei der in Fig. 2 gezeigten Schaltungsvorrichtung 1 ist die Primärspule 144 des ersten Transformators 140 in den Laststrompfad 110 des ersten Transistors 120 integriert. Die Sekundärspule 142 des ersten Transformators 140 ist mit einem ihrer Anschlüsse mit dem Steueranschluss 226 eines weiteren Transistors 220 verbunden. Der weitere Anschluss der Sekundärspule 142 des ersten Transformators 140 ist mit dem gemeinsamen Steuereinheit-Steueranschluss Pfad 10 verbunden. Die Primärspule 242 des weiteren Transformators 220 ist in den Laststrompfad 210 des weiteren Transistors 220 integriert. Die Sekundärspule 244 des weiteren Transformators 240 ist mit einem ihrer Anschlüsse mit dem Steueranschluss 126 des ersten Transistors 120 verbunden. Der zweite Anschluss der Sekundärspule 244 ist mit dem gemeinsamen Steuereinheit-Steueranschluss Pfad 10 verbunden. Der jeweilige Transistor 120, 220 wird durch die Stromänderung des benachbarten Transistors 120, 220 beschleunigt oder ausgebremst.

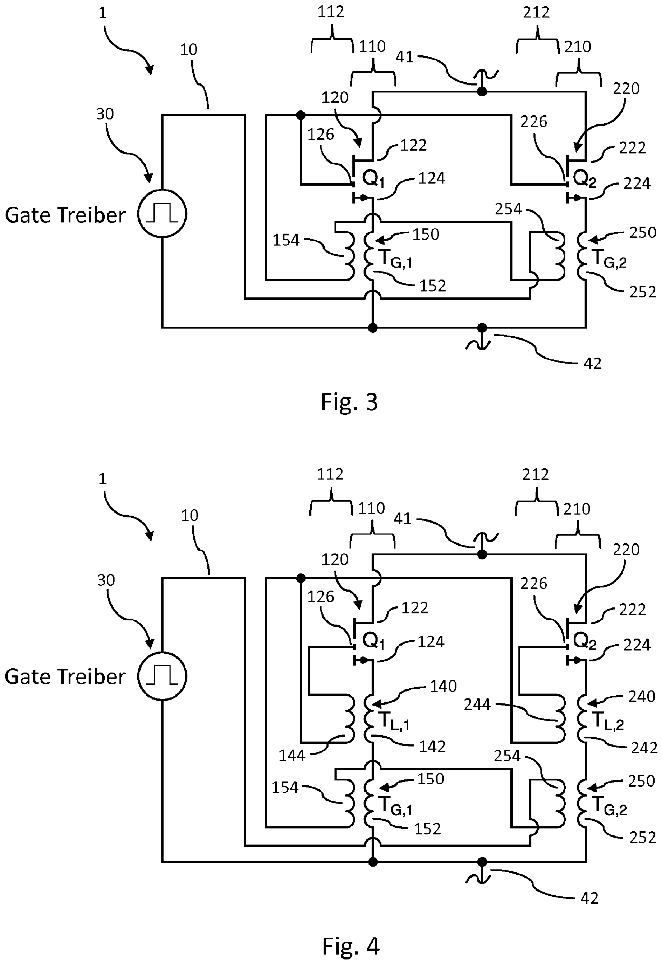

Die Fig. 3 zeigt ein schematisches Schaltbild einer Schaltungsvorrichtung gemäß einer weiteren beispielhaften Schaltvorrichtung. Bei der in Fig. 3 gezeigten Schaltungsvorrichtung 1 ist die Primärspule 144 des ersten Transformators 140 in den Laststrompfad 110 des ersten Transistors 120 integriert. Die Sekundärspule 142 des ersten Transformators 140 ist mit der Sekundärspule 254 eines weiteren Transformators 250 verbunden, wobei der weitere Transformator 250 in den Laststrompfad 210 eines weiteren Transistors 220 integriert ist. Die Sekundärspulen 154, 254 der Transformatoren 150, 250 sind in Reihe geschaltet und mit dem gemeinsamen Steuereinheit-Steueranschluss Pfad 10 in Reihe verschaltet. Dadurch können alle Transistoren 120, 220 über den gemeinsamen Steuereinheit-Steueranschluss Pfad 10 global beschleunigt oder abgebremst werden.

Die Fig. 4 zeigt ein schematisches Schaltbild einer Schaltungsvorrichtung gemäß einer Ausführungsform der vorliegenden Erfindung. Bei der in Fig. 4 gezeigten Schaltungsvorrichtung 1 besitzt jeder der zwei Transistoren 120, 220 einen ersten und einen zweiten Transformator 140, 150; 240, 250. Die Primärspulen 142, 152; 242, 252 sind in die Laststrompfade 110, 210 der Transistoren integriert. Die Sekundärspulen 144, 244 der ersten Transformatoren 140, 240 sind mit einem ihrer Anschlüsse mit den Steueranschlüssen 126, 226 der Transistoren verbunden. Mit dem anderen Anschluss sind die Sekundärspulen 144, 244 der ersten Transformatoren 140, 240 mit dem gemeinsamen Steuereinheit-Steueranschluss Pfad 10 verbunden. Die Sekundärspulen 154, 254 der zweiten Transformatoren 150, 250 sind in Reihe geschaltet und mit dem gemeinsamen Steuereinheit-Steueranschluss Pfad 10 in Reihe geschaltet. Die ersten Transformatoren 140, 240 sind insbesondere derart ausgelegt und angeordnet, dass bei einem Einschaltvorgang der Schaltelemente 120, 220 an den Steueranschlüssen der Schaltelemente 126, 226 eine zusätzliche Spannung anliegt. Die Transformatoren verhalten sich während des Einschaltvorgangs der Schaltelemente also wie eine zusätzliche Spannungsquelle, wodurch sich ein Steuersignal bzw. ein Steuerstrom erhöht oder erniedrigt. Somit kann die Schaltgeschwindigkeit der Schaltelemente 120, 240 vorteilhafterweise beschleunigt oder ausgebremst werden. Die ersten Transformatoren 140, 240 limitieren oder erhöhen die Stromänderung während des Schaltens der Transistoren 120, 220. Die Stromänderung ruft eine Spannung proportional zur Stromänderung hervor, wobei die Spannung in die Steuerstrompfade 112, 212 wieder eingekoppelt wird und zu einer Abbremsung oder Beschleunigung der Schaltgeschwindigkeit führt. Durch diese Maßnahme, wird ein gleichmäßiger Stromanstieg der einzelnen Stränge erreicht. Die zweiten Transformatoren 150, 250 stellen eine zweite unabhängige Spannung zur Verfügung, welche wiederum proportional zur Stromänderung im Lastrompfad ist. Die Spannungen der Sekundärspulen 154, 254 der zweiten Transformatoren 150, 250 werden in Reihe geschaltet und in dem gemeinsamen Steuereinheit-Steueranschluss Pfad 10 der Transistoren 120, 220 eingespeist. Eine negative Spannung erhöht die Schaltgeschwindigkeit des gesamten Moduls. Durch die Rückkopplung durch die Transformatoren 150, 250 kann die Stromänderung insgesamt erhöht werden, wodurch die Schaltverluste reduziert werden.

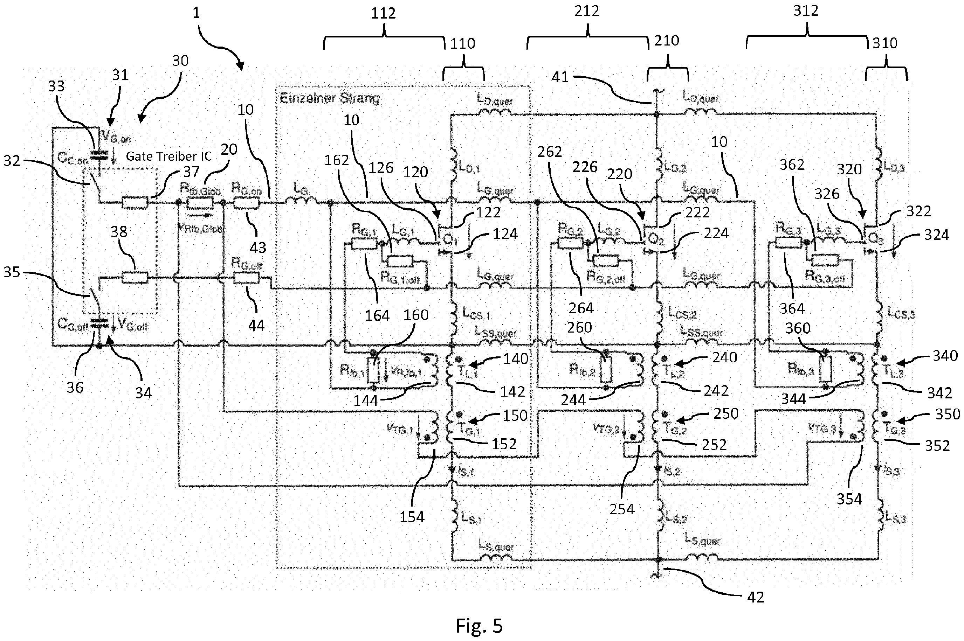

Die Fig. 5 zeigt ein weiteres schematisches Schaltbild einer Schaltungsvorrichtung 1 gemäß einer bevorzugten Ausführungsform der vorliegenden Erfindung. Die Schaltungsvorrichtung 1 umfasst mehrere parallel geschaltete, elektrisch gesteuerte Schaltelemente 120, 220, 320 mit mehreren Kopplungselementen 140, 240, 340; 150, 250, 350 und einer Steuereinheit 30. Bei den Kopplungselementen 140, 240, 340; 150, 250, 350 handelt es sich um Transformatoren mit einer Primärspule 152, 252, 352 und einer Sekundärspule 154, 254, 354. Die Primärspule 152, 252, 352 und die Sekundärspule 154, 254, 354 sind induktiv miteinander gekoppelt.

Die elektrisch gesteuerten Schaltelemente 120, 220, 320 sind beispielsweise Halbleiterbauelemente bzw. Transistoren. Die Schaltelemente 120, 220, 320 weisen einen ersten Laststromanschluss 122, 222, 322 für den Zufluss eines zu schaltenden Laststroms und einen zweiten Laststromanschluss 124, 224, 324 für den Abfluss des zu schaltenden Laststroms auf. Zudem weisen die Schaltelemente 120, 220, 320 einen Steueranschluss 126, 226, 326 zum Steuern der Schaltelemente mittels eines Steuersignals auf. Bei den Laststromanschlüssen 122, 222, 322; 124, 224, 324 handelt es sich insbesondere um die Drain- und Source-Anschlüsse eines Transistors. Bei dem Steueranschluss 126, 226, 326 handelt es sich insbesondere um den Gate-Anschluss eines Transistors.

Die Schaltvorrichtung 1 umfasst bzw. ist unterteilt in Laststrompfade bzw. Laststromkreise 110, 210, 310 und Steuerstrompfade bzw. Steuerstromkreise 112, 212, 312. Die ersten und die zweiten Laststromanschlüsse 122, 222, 322; 124, 224, 324 der Schaltelemente 120, 220, 320 sind in die Laststrompfade 110, 210, 310 integriert, während die Steueranschlüsse 126, 226, 326 der Schaltelemente 120, 220, 320 in die Steuerstrompfade 112, 212, 312 integriert sind. In den Laststrompfaden 110, 210, 310 fließen Lastströme, welcher mit Hilfe der Schaltelemente bzw. mit Hilfe der Steuerstrompfade 112, 212, 312 gesteuert werden können. Über die parallel geschalteten Laststrompfade 110, 210, 310 kann ein Verbraucher bzw. eine Last integriert sein, die über die beiden Lastanschlüsse 41, 42 mit den Laststrompfaden 110, 210, 310 verbunden ist. Der Verbraucher bzw. die Last kann über die gemeinsame Steuereinheit ein- und ausgeschaltet werden.

Ein einzelner Strang umfasst einen Halbleiterchip 120, 220, 320. Die parasitäre Drain Induktivität wird durch $L_{D,1}$, $L_{D,2}$, $L_{D,3}$ repräsentiert. Die parasitäre Source Induktivität wird durch $L_{S,1}$, $L_{S,2}$, $L_{S,3}$ repräsentiert. Die Common Source Induktivität, wird durch $L_{CS,1}$, $L_{CS,2}$, $L_{CS,3}$ dargestellt, wobei sich $i_S$ und $i_G$ einen Strompfad teilen. Die parasitäre Gate Induktivität wird durch $L_{G,1}$,

$L_{G,2}$, $L_{G,3}$ repräsentiert. Die Widerstände 164, 264, 364 ($R_{G,1}$, $R_{G,2}$, $R_{G,3}$) erlauben das kontrollierte Einschalten, die Widerstände 162, 262, 362 ($R_{G,1,off}$, $R_{G,2,off}$, $R_{G,3,off}$) das Ausschalten der Transistoren 120, 220, 320. Die Widerstände 43, 44 ($R_{G,on}$, $R_{G,off}$) erlauben das kontrollieren der gesamten Schaltgeschwindigkeit für alle Stränge. Die Induktivität $L_{D,quer}$ stellt die Drain-Querverbindung zwischen den Strängen dar. Die Induktivität $L_{S,quer}$ stellt die Source-Querverbindung zwischen den Strängen dar. Die Induktivität $L_{G,quer}$ stellt die Gate-Querverbindung zwischen den Strängen dar, hier jeweils für Ein- und Ausschalten separat. Die Induktivität $L_{SS,quer}$ stellt die Source-Sense-Querverbindung zwischen den Strängen dar, auf den sich der Gate-Treiber referenziert.

Die Steuereinheit 30 ist derart ausgelegt, ein Steuersignal bereitzustellen, welches über den gemeinsamen Gate-Treiber Pfad 10 an die die Steueranschlüsse 126, 226, 326 der Schaltelemente 120, 220, 320 geführt bzw. angelegt wird. Im einfachsten Fall umfasst die Steuereinheit 30 lediglich eine Spannungsquelle zum Bereitstellen einer Steuer- oder Gate-Spannung. Insbesondere umfasst oder ist die Steuereinheit ein Standard Gate-Treiber. Der Gate-Treiber besteht aus einem konventionellen, käuflichen Gate-Treiber IC, mit einem separaten Pfad zum Einschalten und einem Pfad zum Ausschalten des Transistors. Der Gate-Treiber IC hat einen endlichen internen Widerstand, angedeutet durch die Widerstände 37, 38. Zwei externe Kapazitäten 33, 34 dienen zur Spannungsversorgung des Gate-Treiber IC. Die entsprechenden Spannungen werden mithilfe des Gate-Treiber IC an das Gate des Transistors angelegt (durch Schließen der Schalter). Die parasitäre Induktivität der Gate-Treiber-Schaltung wird durch $L_G$ repräsentiert.

Die Kopplungselemente 140, 240, 340; 150, 250, 350 bzw. die Transformatoren dienen zum galvanisch getrennten Übertragen von Energie aus den Laststrompfaden 110, 210, 310 in die Steuerstrompfade 112, 212, 312 mittels der ersten Transformatoren 140, 240, 340 sowie aus den Laststrompfaden 110, 210, 310 in den gemeinsamen Gate-Treiber Pfad 10 mittels der zweiten Transformatoren 150, 250, 350.

Das Koppeln bzw. Übertragen von Energie aus den Laststrompfaden 110, 210, 310 in die Steuerstrompfade 112, 212, 312 erfolgt in dem gezeigten Ausführungsbeispiel induktiv mit Hilfe der ersten Transformatoren 140, 240, 340. Die ersten Transformatoren 140, 240, 340 sorgen dafür, dass sich infolge einer zeitlichen Änderung der Lastströme in den Laststrompfaden 110 210, 310 in den Primärspulen 142, 242, 342 ein Magnetfeld aufbaut bzw. ändert, welches auch die Sekundärspulen 144, 244, 344 durchdringt bzw. erfasst. In der Sekundärspulen 144, 244, 344 wird somit eine Spannung induziert, welche direkt proportional zur zeitlichen Änderung der Lastströme ist. Die Transformatoren 140, 240, 340; 150, 250, 350 verhalten sich während des Einschaltvorgangs zeitweise wie eine zusätzliche Spannungsquelle, wodurch der Steuerstrom bzw. Gate-Strom erhöht wird.

Im Folgenden wird die Funktionsweise eines einzelnen Strangs der parallel geschalteten Transistoren 120, 220, 320 ($Q_1$, $Q_2$, $Q_3$) beschrieben. Der Transformator 140 ($T_{L,1}$) limitiert oder erhöht die Stromänderung $\left(\frac{di_S}{dt}\right)$ während des Schaltens des Transistors 120 (Qi). Die Stromänderung ruft eine Spannung $V_{R,fb,1}$ proportional zu $\left(\frac{di_S}{dt}\right)$ hervor, wobei die Spannung $V_{R,fb,1}$ in den Steuerstrompfad 112, 212, 312 wieder eingekoppelt wird und zu einer Abbremsung oder Beschleunigung der Schaltgeschwindigkeit führt. Durch diese Maßnahme, wird ein gleichmäßiger Stromanstieg der einzelnen Stränge erreicht.

Ein Nachteil dabei ist die erhöhte Verlustleistung. Dies wird durch das Koppeln bzw. Übertragen von Energie aus dem Laststrompfad 110, 210, 310 in den gemeinsamen Gate-Treiber Pfad 10 kompensiert. Dies geschieht auf ähnliche Weise wie beim ersten Transformator 140 ($T_{L,1}$). Ein zweiter Transformator 150 ($T_{G,1}$), vergleichbar mit 140 ($T_{L,1}$), stellt eine zweite unabhängige Spannung $V_{TG,1}$ zur Verfügung, welche wiederum proportional zu $\left(\frac{di_S}{dt}\right)$ ist. Die Spannungen $V_{TG,1}$, $V_{TG,2}$ und $V_{TG,3}$ werden in Reihe geschaltet und in dem gemeinsamen Gate-Treiber Pfad 10 der Transistoren 120, 220, 320 ($Q_1$, $Q_2$, $Q_3$) über den Widerstand 20 ($R_{fb,Glob}$) eingespeist. Eine negative Spannung $V_{Rfb,Glob}$ erhöht die Schaltgeschwindigkeit des gesamten Moduls. Durch die Rückkopplung durch die Transformatoren 150, 250, 350 ($T_{G,1}$, $T_{G,2}$, $T_{G,3}$) kann die Stromänderung insgesamt erhöht werden, wodurch die Schaltverluste reduziert werden. Die einzelnen Pfade werden durch selektive Abbremsung, mithilfe der ersten Transformatoren 140, 240, 340 ($T_{L,1}$, $T_{L,2}$, $T_{L,3}$) auf einen gleichen Stromänderungswert getrimmt $\left(\left(\frac{di_{S,1}}{dt}\right) = \left(\frac{di_{S,2}}{dt}\right) = \left(\frac{di_{S,3}}{dt}\right)\right)$.

Die dieser Patentanmeldung zu Grunde liegende Erfindung entstand in einem Projekt, welches unter der Bezeichnung "Performante leistungselektronische Systeme durch hochoptimierte Aufbau- und Verbindungstechnik" (peakAVT) vom BMBF gefördert wurde.

Bezugszeichenliste

| | |
|---|---|
| 1 | Schaltungsvorrichtung |
| 10 | Steueranschluss-Steuersignal Pfad |
| 20 | Widerstand |
| 30 | Steuereinheit |
| 31 | erste Steuer-Spannungsquelle / Spannungsquelle des Einschaltepfads |
| 32 | erster Steuerschalter / Schalter des Einschaltepfads |
| 33 | Kapazität des Einschaltepfads |
| 34 | zweite Steuer-Spannungsquelle / Spannungsquelle des Ausschaltepfads |
| 35 | zweiter Steuerschalter / Schalter des Ausschaltepfads |
| 36 | Kapazität des Ausschaltepfads |
| 37 | interner Widerstand des Einschaltepfads der Steuereinheit |
| 38 | interner Widerstand des Ausschaltepfads der Steuereinheit |
| 41 | Lastanschluss |
| 42 | Lastanschluss |
| 43 | Widerstand / Einschaltwiderstand |
| 44 | Widerstand / Ausschaltwiderstand |
| 110 | Laststrompfad / Laststromkreis |
| 112 | Steuerstrompfad / Steuerstromkreis |
| 120 | elektrisch gesteuertes Schaltelement / Transistor |
| 122 | erster Laststromanschluss / Drain oder Source |
| 124 | zweiter Laststromanschluss / Source oder Drain |
| 126 | Steueranschluss / Gate |
| 140 | erstes Kopplungselement / erster Transformator |
| 142 | Primärspule / Primärseite des ersten Transformators |
| 144 | Sekundärspule / Sekundärseite des ersten Transformators |
| 150 | zweites Kopplungselement / zweiter Transformator |
| 152 | Primärspule / Primärseite des zweiten Transformators |
| 154 | Sekundärspule / Sekundärseite des zweiten Transformators |
| 160 | Widerstand |
| 162 | Widerstand / externer Einschaltwiderstand |
| 164 | Widerstand / externer Ausschaltwiderstand |
| 210 | Laststrompfad / Laststromkreis |
| 212 | Steuerstrompfad / Steuerstromkreis |
| 220 | elektrisch gesteuertes Schaltelement / Transistor |
| 222 | erster Laststromanschluss / Drain oder Source |
| 224 | zweiter Laststromanschluss / Source oder Drain |
| 226 | Steueranschluss / Gate |
| 240 | erstes Kopplungselement / erster Transformator |
| 242 | Primärspule / Primärseite des ersten Transformators |
| 244 | Sekundärspule / Sekundärseite des ersten Transformators |
| 250 | zweites Kopplungselement / zweiter Transformator |
| 252 | Primärspule / Primärseite des zweiten Transformators |

| Ref. | Beschreibung |
|---|---|
| 254 | Sekundärspule / Sekundärseite des zweiten Transformators |
| 260 | Widerstand |
| 262 | Widerstand / externer Einschaltwiderstand |
| 264 | Widerstand / externer Ausschaltwiderstand |
| 310 | Laststrompfad / Laststromkreis |
| 312 | Steuerstrompfad / Steuerstromkreis |
| 320 | elektrisch gesteuertes Schaltelement / Transistor |
| 322 | erster Laststromanschluss / Drain oder Source |
| 324 | zweiter Laststromanschluss / Source oder Drain |
| 326 | Steueranschluss / Gate |
| 340 | erstes Kopplungselement / erster Transformator |
| 342 | Primärspule / Primärseite des ersten Transformators |
| 350 | zweites Kopplungselement / zweiter Transformator |
| 352 | Primärspule / Primärseite des zweiten Transformators |
| 354 | Sekundärspule / Sekundärseite des zweiten Transformators |
| 360 | Widerstand |
| 362 | Widerstand / externer Einschaltwiderstand |
| 364 | Widerstand / externer Ausschaltwiderstand |
| $L_G$ | parasitäre Induktivität der Gate-Treiber-Schaltung |
| $L_{G,quer}$ | parasitäre Induktivität der Gate-Querverbindung |
| $L_{SS,quer}$ | parasitäre Induktivität der Source-Sense-Querverbindung |
| $L_{S,quer}$ | parasitäre Induktivität der Source-Querverbindung |
| $L_{D,1}$ | parasitäre Drain Induktivität |
| $L_{D,2}$ | parasitäre Drain Induktivität |
| $L_{D,3}$ | parasitäre Drain Induktivität |
| $L_{G,1}$ | parasitäre Gate Induktivität |
| $L_{G,2}$ | parasitäre Gate Induktivität |
| $L_{G,3}$ | parasitäre Gate Induktivität |
| $L_{CS,1}$ | parasitäre Common-Source Induktivität |
| $L_{CS,2}$ | parasitäre Common-Source Induktivität |
| $L_{CS,3}$ | parasitäre Common-Source Induktivität |
| $L_{S,1}$ | parasitäre Source Induktivität |
| $L_{S,2}$ | parasitäre Source Induktivität |
| $L_{S,3}$ | parasitäre Source Induktivität |
| $Q_1$ | Leistungstransistor, z.B. GaN HEMT |
| $Q_2$ | Leistungstransistor, z.B. GaN HEMT |
| $Q_3$ | Leistungstransistor, z.B. GaN HEMT |
| $R_{G,on}$ | Einschaltwiderstand |
| $R_{G,off}$ | Ausschaltwiderstand |
| $R_{G,1}$ | Gatevorwiderstand für den Einschaltvorgang |
| $R_{G,2}$ | Gatevorwiderstand für den Einschaltvorgang |
| $R_{G,3}$ | Gatevorwiderstand für den Einschaltvorgang |
| $R_{G,1,off}$ | Gatevorwiderstand für den Ausschaltvorgang |
| $R_{G,2,off}$ | Gatevorwiderstand für den Ausschaltvorgang |
| $R_{G,3,off}$ | Gatevorwiderstand für den Ausschaltvorgang |
| $T_{L,1}$ | erster Transformator |
| $T_{L,2}$ | erster Transformator |
| $T_{L,3}$ | erster Transformator |
| $R_{fb,1}$ | Widerstand |
| $R_{fb,2}$ | Widerstand |
| $R_{fb,3}$ | Widerstand |
| $V_{R,fb,1}$ | Spannung über Widerstand $R_{fb,1}$ |
| $V_{R,fb,2}$ | Spannung über Widerstand $R_{fb,2}$ |
| $V_{R,fb,3}$ | Spannung über Widerstand $R_{fb,3}$ |
| $T_{G,1}$ | zweiter Transformator |
| $T_{G,2}$ | zweiter Transformator |
| $T_{G,3}$ | zweiter Transformator |
| $V_{TG,1}$ | Spannung |
| $VTG,2$ | Spannung |
| $VTG,3$ | Spannung |
| $R_{fb,Glob}$ | Widerstand |
| $V_{Rfb,Glob}$ | Spannung |
| $V_{G,on}$ | Einschaltspannung |
| $V_{G,off}$ | Ausschaltspannung |
| $C_{G,on}$ | Kapazität |
| $C_{G,off}$ | Kapazität |
| $i_{S,1}$ | Strom im Laststromkreis von $Q_1$ / Laststrom / Source-Strom |
| $i_{S,2}$ | Strom im Laststromkreis von $Q_2$ / Laststrom / Source-Strom |
| $i_{S,3}$ | Strom im Laststromkreis von $Q_3$ / Laststrom / Source-Strom |

**Patentansprüche**

1. Schaltungsvorrichtung (1) aufweisend:

   - eine Mehrzahl von elektrisch gesteuerten Schaltelementen (120, 220, 320), wobei die Mehrzahl von elektrisch gesteuerten Schaltelementen (120, 220, 320) parallel zueinander geschaltet sind und über einen gemeinsamen Steuereinheit-Steueranschluss Pfad (10) miteinander verschaltet sind,
   - eine Steuereinheit (30) zum Bereitstellen eines Steuersignals;
   wobei jedes der elektrisch gesteuerten Schaltelemente (120, 220, 320) aufweist:

      - einen ersten Laststromanschluss (122, 222, 322) für den Zufluss eines zu schaltenden Laststroms, einen zweiten Laststromanschluss (124, 224, 324) für den Abfluss des zu schaltenden Laststroms und einen Steueranschluss (126, 226, 326) zum Steuern des Schaltelements (120, 220, 320) mittels des Steuersignals, wobei der erste und der zweite Laststromanschluss (122, 222, 322, 124, 224, 324) in einem Laststrompfad (110, 210, 310) der Schaltungsvorrichtung (1) integriert sind und wobei der Steueranschluss (126, 226, 326) in einem Steuerstrompfad (112, 212, 312) der Schaltungsvorrichtung (1) integriert ist;
- ein Kopplungselement (140, 240, 340) zum galvanisch getrennten Übertragen von Energie,

wobei ein erster Teil des Kopplungselements (142, 242, 342), wenigstens zwei Anschlüsse aufweist und in Serie mit dem Laststrompfad (110, 210, 310) verschaltet ist, und
ein zweiter Teil des Kopplungselements (144, 244, 344) wenigstens zwei Anschlüsse aufweist, wobei zumindest einer der Anschlüsse mit dem gemeinsamen Steuereinheit-Steueranschluss Pfad (10) verbunden ist, wobei zumindest ein weiterer Anschluss des zweiten Teils des Kopplungselements (144, 244, 344) mit dem Steueranschluss (126, 226, 326) des jeweiligen elektrisch gesteuerten Schaltelements (120, 220, 320) verbunden ist,
wobei jedes der elektrisch gesteuerten Schaltelemente (120, 220, 320) ein weiteres Kopplungselement aufweist, **dadurch gekennzeichnet, dass** die zweiten Teile der Kopplungselemente (142, 242, 342) der weiteren Kopplungselemente (150, 250, 350) der elektrisch gesteuerten Schaltelemente (120, 220, 320) in Serie verschaltet sind,
wobei die Serienschaltung der zweiten Teile der Kopplungselemente (142, 242, 342) der weiteren Kopplungselemente (150, 250, 350) in Serie mit dem gemeinsamen Steuereinheit-Steueranschluss Pfad (10) verschaltet ist.

2. Schaltungsvorrichtung (1) nach Anspruch 1, wobei zumindest einer der Anschlüsse des zweiten Teils des Kopplungselements (142, 242, 342) eines ersten elektrisch gesteuerten Schaltelements (120, 220, 320) mit dem Steueranschluss (126, 226, 326) eines weiteren elektrisch gesteuerten Schaltelements (120, 220, 320) verbunden ist,

wobei zumindest ein weiterer Anschluss des zweiten Teils des Kopplungselements (142, 242, 342) des ersten elektrisch gesteuerten Schaltelements (120, 220, 320) mit dem gemeinsamen Steuereinheit-Steueranschluss Pfad (10) verbunden ist,
wobei zumindest einer der Anschlüsse des zweiten Teils des Kopplungselements (142, 242, 342) des weiteren elektrisch gesteuerten Schaltelements (120, 220, 320) mit dem Steueranschluss (126, 226, 326) des ersten elektrisch gesteuerten Schaltelements (120, 220, 320) verbunden ist und
wobei zumindest ein weiterer Anschluss des zweiten Teils des Kopplungselements (142, 242, 342) des weiteren elektrisch gesteuerten Schaltelements (120, 220, 320) mit dem gemeinsamen Steuereinheit-Steueranschluss Pfad (10) verbunden ist.

3. Schaltungsvorrichtung (1) nach Anspruch 1, wobei die zweiten Teile der Kopplungselemente (142, 242, 342) der elektrisch gesteuerten Schaltelemente (120, 220, 320) in Serie verschaltet sind,
wobei die Serienschaltung der zweiten Teile der Kopplungselemente (142, 242, 342) in Serie mit dem gemeinsamen Steuereinheit-Steueranschluss Pfad (10) verschaltet ist.

4. Schaltungsvorrichtung (1) nach einem der vorherigen Ansprüche, wobei das Kopplungselement (140, 240, 340; 150, 250, 350) ein Transformator ist,
wobei der erste Teil des Kopplungselements eine Primärspule (142, 242, 342; 152, 252, 352) des Transformators ist und der zweite Teil des Kopplungselements eine Sekundärspule (144, 244, 344; 154, 254, 354) des Transformators ist.

5. Schaltungsvorrichtung (1) nach einem der vorherigen Ansprüche, wobei die Steuereinheit (30) zumindest eine Spannungsquelle oder Stromquelle (31, 34) und/oder einen Standard Gate Treiber aufweist.

6. Verfahren zur homogenen Stromverteilung und/oder zur Reduzierung von Schaltverlusten für parallel geschaltete, elektrisch gesteuerte Schaltelemente (120, 220, 320) aufweisend:

- Bereitstellen von parallel geschalteten, elektrisch gesteuerten Schaltelementen (120, 220, 320) wobei jedes der elektrisch gesteuerten Schaltelemente (120, 220, 320) aufweist:
einen ersten Laststromanschluss (122, 222, 322) für den Zufluss eines zu schaltenden Laststroms, einem zweiten Laststromanschluss (124, 224, 324) für den Abfluss des zu schaltenden Laststroms und einem Steueranschluss (126, 226, 326) zum Steuern des Schaltelements (120, 220, 320), wobei der erste und der zweite Laststromanschluss (124, 224, 324; 126, 226, 326) in einen Laststrompfad (110, 210, 310) und der Steueranschluss (126, 226, 326) in einen Steuerstrompfad (112, 212, 312) integriert wird;

- Steuern der parallel geschalteten, elektrisch gesteuerten Schaltelemente (120, 220, 320) mit Hilfe einer Steuereinheit (30) über einen gemeinsamen Steuereinheit-Steueranschluss Pfad (10);

- galvanisch getrenntes Übertragen von Energie mit Hilfe eines Kopplungselements (140, 240, 340),

wobei ein erster Teil des Kopplungselements (142, 242, 342), wenigstens zwei Anschlüsse aufweist und in Serie mit dem Laststrompfad (110, 210, 310) verschaltet ist, und

ein zweiter Teil des Kopplungselements (144, 244, 344) wenigstens zwei Anschlüsse aufweist, wobei zumindest einer der Anschlüsse mit dem gemeinsamen Steuereinheit-Steueranschluss Pfad (10) verbunden ist;

- galvanisch getrenntes Übertragen von Energie mit Hilfe der Kopplungselemente (140, 240, 340) aus den Laststrompfaden (110, 210, 310) in die Steuerstrompfade (112, 212, 312) des jeweiligen elektrisch gesteuerten Schaltelements (120, 220, 320),

wobei zumindest ein weiterer Anschluss des zweiten Teils des Kopplungselements (144, 244, 344) mit dem Steueranschluss (126, 226, 326) des jeweiligen elektrisch gesteuerten Schaltelements (120, 220, 320) verbunden ist,

wobei jedes der elektrisch gesteuerten Schaltelemente (120, 220, 320) ein weiteres Kopplungselement aufweist;

- galvanisch getrenntes Übertragen von Energie mit Hilfe der weiteren Kopplungselemente (150, 250, 350) aus den Laststrompfaden (110, 210, 310) der elektrisch gesteuerten Schaltelemente (120, 220, 320) in den gemeinsamen Steuereinheit-Steueranschluss Pfad (10),

**dadurch gekennzeichnet, dass** die zweiten Teile der Kopplungselemente (142, 242, 342) der weiteren Kopplungselemente (150, 250, 350) der elektrisch gesteuerten Schaltelemente (120, 220, 320) in Serie verschaltet sind,

wobei die Serienschaltung der zweiten Teile der Kopplungselemente (142, 242, 342) der weiteren Kopplungselemente (150, 250, 350) in Serie mit dem gemeinsamen Steuereinheit-Steueranschluss Pfad (10) verschaltet ist.

7. Verfahren nach Anspruch 6. wobei das Verfahren weiter aufweist:

- galvanisch getrenntes Übertragen von Energie mit Hilfe eines Kopplungselements (140, 240, 340) aus dem Laststrompfad (110, 210, 310) in den Steuerstrompfad (112, 212, 312).

8. Verfahren nach Anspruch 6, wobei zumindest einer der Anschlüsse des zweiten Teils des Kopplungselements (142, 242, 342) eines ersten elektrisch gesteuerten Schaltelements (120, 220, 320) mit dem Steueranschluss (126, 226, 326) eines weiteren elektrisch gesteuerten Schaltelements (120, 220, 320) verbunden ist,

wobei zumindest ein weiterer Anschluss des zweiten Teils des Kopplungselements (142, 242, 342) des ersten elektrisch gesteuerten Schaltelements (120, 220, 320) mit dem gemeinsamen Steuereinheit-Steueranschluss Pfad (10) verbunden ist,

wobei zumindest einer der Anschlüsse des zweiten Teils des Kopplungselements (142, 242, 342) des weiteren elektrisch gesteuerten Schaltelements (120, 220, 320) mit dem Steueranschluss (126, 226, 326) des ersten elektrisch gesteuerten Schaltelements (120, 220, 320) verbunden ist,

wobei zumindest ein weiterer Anschluss des zweiten Teils des Kopplungselements (142, 242, 342) des weiteren elektrisch gesteuerten Schaltelements (120, 220, 320) mit dem gemeinsamen Steuereinheit-Steueranschluss Pfad (10) verbunden ist, wobei das Verfahren weiter aufweist:

- galvanisch getrenntes Übertragen von Energie mit Hilfe eines Kopplungselements (140, 240, 340) aus dem Laststrompfad (110, 210, 310) des ersten elektrisch gesteuerten Schaltelements (120, 220, 320) in den Steuerstrompfad (112, 212, 312) des weiteren elektrisch gesteuerten Schaltelements (120, 220, 320),

- galvanisch getrenntes Übertragen von Energie mit Hilfe eines Kopplungselements (140, 240, 340) aus dem Laststrompfad (110, 210, 310) des weiteren elektrisch gesteuerten Schaltelements (120, 220, 320) in den Steuerstrompfad (112, 212, 312) des ersten elektrisch gesteuerten Schaltelements (120, 220, 320).

9. Verfahren nach Anspruch 6, wobei die zweiten Teile der Kopplungselemente (142, 242, 342) der elektrisch gesteuerten Schaltelemente (120, 220, 320) in Serie verschaltet sind,
wobei die Serienschaltung der zweiten Teile der Kopplungselemente (142, 242, 342) in Serie mit dem gemeinsamen Steuereinheit-Steueranschluss Pfad (10) verschaltet ist, wobei das Verfahren weiter aufweist:

- galvanisch getrenntes Übertragen von Energie mit Hilfe der Kopplungselemente (150, 250, 350) aus den Laststrompfaden (110, 210, 310) der elektrisch gesteuerten Schaltelemente (120, 220, 320) in den gemeinsamen Steuereinheit-Steueranschluss Pfad (10).

**Claims**

1.  Circuit device (1) comprising:

    - a plurality of electrically controlled circuit elements (120, 220, 320), the plurality of electrically controlled circuit elements (120, 220, 320) being connected in parallel with one another and being interconnected by means of a common control-unit/control-terminal path (10),
    - a control unit (30) for providing a control signal; each of the electrically controlled circuit elements (120, 220, 320) comprising:

        - a first load current terminal (122, 222, 322) for the inflow of a load current to be switched, a second load current terminal (124, 224, 324) for the outflow of the load current to be switched and a control terminal (126, 226, 326) for controlling the circuit element (120, 220, 320) by means of the control signal, the first and the second load current terminal (122, 222, 322, 124, 224, 324) being integrated in a load current path (110, 210, 310) of the circuit device (1) and the control terminal (126, 226, 326) being integrated in a control current path (112, 212, 312) of the circuit device (1);
        - a coupling element (140, 240, 340) for transmitting energy in a galvanically isolated manner,

            a first part of the coupling element (142, 242, 342) comprising at least two terminals and being connected in series with the load current path (110, 210, 310), and
            a second part of the coupling element (144, 244, 344) comprising at least two terminals, at least one of the terminals being connected to the common control-unit/control-terminal path (10),

at least one additional terminal of the second part of the coupling element (144, 244, 344) being connected to the control terminal (126, 226, 326) of the relevant electrically controlled circuit element (120, 220, 320),
each of the electrically controlled circuit elements (120, 220, 320) comprising an additional coupling element,
**characterized in that** the second parts of the coupling elements (142, 242, 342) of the additional coupling elements (150, 250, 350) of the electrically controlled circuit elements (120, 220, 320) are connected in series,
the series circuit of the second parts of the coupling elements (142, 242, 342) of the additional coupling elements (150, 250, 350) being connected in series with the common control-unit/control-terminal path (10).

2.  Circuit device (1) according to claim 1, wherein at least one of the terminals of the second part of the coupling element (142, 242, 342) of a first electrically controlled circuit element (120, 220, 320) is connected to the control terminal (126, 226, 326) of an additional electrically controlled circuit element (120, 220, 320),

    wherein at least one additional terminal of the second part of the coupling element (142, 242, 342) of the first electrically controlled circuit element (120, 220, 320) is connected to the common control-unit/control-terminal path (10),
    wherein at least one of the terminals of the second part of the coupling element (142, 242, 342) of the additional electrically controlled circuit element (120, 220, 320) is connected to the control terminal (126, 226, 326) of the first electrically controlled circuit element (120, 220, 320), and
    wherein at least one additional terminal of the second part of the coupling element (142, 242, 342) of the additional electrically controlled circuit element (120, 220, 320) is connected to the common control-unit/control-terminal path (10).

3.  Circuit device (1) according to claim 1, wherein the second parts of the coupling elements (142, 242, 342) of the electrically controlled circuit elements (120, 220, 320) are connected in series, wherein the series circuit of the second parts of the coupling elements (142, 242, 342) is connected in series with the common control-unit/control-terminal path (10).

4.  Circuit device (1) according to any of the preceding claims, wherein the coupling element (140, 240, 340; 150, 250, 350) is a transformer,

wherein the first part of the coupling element is a primary coil (142, 242, 342; 152, 252, 352) of the transformer and the second part of the coupling element is a secondary coil (144, 244, 344; 154, 254, 354) of the transformer.

5. Circuit device (1) according to any of the preceding claims, wherein the control unit (30) comprises at least one voltage source or current source (31, 34) and/or a standard gate driver.

6. Method for the homogeneous current distribution and/or for the reduction of switching losses for electrically controlled circuit elements (120, 220, 320) connected in parallel, comprising:

   - providing electrically controlled circuit elements (120, 220, 320) connected in parallel, each of the electrically controlled circuit elements (120, 220, 320) comprising:

      a first load current terminal (122, 222, 322) for the inflow of a load current to be switched, a second load current terminal (124, 224, 324) for the outflow of the load current to be switched and a control terminal (126, 226, 326) for controlling the circuit element (120, 220, 320), the first and the second load current terminal (124, 224, 324; 126, 226, 326) being integrated in a load current path (110, 210, 310) and the control terminal (126, 226, 326) being integrated in a control current path (112, 212, 312);

   - controlling the electrically controlled circuit elements (120, 220, 320) connected in parallel by means of a control unit (30) via a common control-unit/control-terminal path (10);
   - transmitting energy in a galvanically isolated manner by means of a coupling element (140, 240, 340),

      a first part of the coupling element (142, 242, 342) comprising at least two terminals and being connected in series with the load current path (110, 210, 310), and
      a second part of the coupling element (144, 244, 344) comprising at least two terminals, at least one of the terminals being connected to the common control-unit/control-terminal path (10);

   - transmitting energy in a galvanically isolated manner by means of the coupling elements (140, 240, 340) from the load current paths (110, 210, 310) to the control current paths (112, 212, 312) of the relevant electrically controlled circuit element (120, 220, 320),

      at least one additional terminal of the second part of the coupling element (144, 244, 344) being connected to the control terminal (126, 226, 326) of the relevant electrically controlled circuit element (120, 220, 320), each of the electrically controlled circuit elements (120, 220, 320) comprising an additional coupling element;

   - transmitting energy in a galvanically isolated manner by means of the additional coupling elements (150, 250, 350) from the load current paths (110, 210, 310) of the electrically controlled circuit elements (120, 220, 320) to the common control-unit/control-terminal path (10),

      **characterized in that** the second parts of the coupling elements (142, 242, 342) of the additional coupling elements (150, 250, 350) of the electrically controlled circuit elements (120, 220, 320) are connected in series,
      the series circuit of the second parts of the coupling elements (142, 242, 342) of the additional coupling elements (150, 250, 350) being connected in series with the common control-unit/control-terminal path (10).

7. Method according to claim 6, wherein the method further comprises:

   - transmitting energy in a galvanically isolated manner by means of a coupling element (140, 240, 340) from the load current path (110, 210, 310) to the control current path (112, 212, 312).

8. Method according to claim 6, wherein at least one of the terminals of the second part of the coupling element (142, 242, 342) of a first electrically controlled circuit element (120, 220, 320) is connected to the control terminal (126, 226, 326) of an additional electrically controlled circuit element (120, 220, 320),

   wherein at least one additional terminal of the second part of the coupling element (142, 242, 342) of the first electrically controlled circuit element (120, 220, 320) is connected to the common control-unit/control-terminal path (10), wherein at least one of the terminals of the second part of the coupling element (142, 242, 342) of the additional electrically controlled circuit element (120, 220, 320) is connected to the control terminal (126, 226, 326) of the first electrically controlled circuit element (120, 220, 320), wherein at least one additional terminal of the second part of the coupling element (142, 242, 342) of the additional electrically controlled circuit element (120, 220, 320) is connected to the common control-unit/control-terminal path (10), wherein the method further comprises:

- transmitting energy in a galvanically isolated manner by means of a coupling element (140, 240, 340) from the load current path (110, 210, 310) of the first electrically controlled circuit element (120, 220, 320) to the control current path (112, 212, 312) of the additional electrically controlled circuit element (120, 220, 320),
- transmitting energy in a galvanically isolated manner by means of a coupling element (140, 240, 340) from the load current path (110, 210, 310) of the additional electrically controlled circuit element (120, 220, 320) to the control current path (112, 212, 312) of the first electrically controlled circuit element (120, 220, 320).

**9.** Method according to claim 6, wherein the second parts of the coupling elements (142, 242, 342) of the electrically controlled circuit elements (120, 220, 320) are connected in series, wherein the series circuit of the second parts of the coupling elements (142, 242, 342) is connected in series with the common control-unit/control-terminal path (10), wherein the method further comprises:

- transmitting energy in a galvanically isolated manner by means of the coupling elements (150, 250, 350) from the load current paths (110, 210, 310) of the electrically controlled circuit elements (120, 220, 320) to the common control-unit/control-terminal path (10).

## Revendications

**1.** Dispositif de commutation ((1) présentant :

- une multiplicité d'éléments de commutation (120, 220, 320) commandés électriquement, où les éléments de commutation (120, 220, 320) commandés électriquement de la multiplicité sont branchés en parallèle les uns par rapport aux autres et sont connectés les uns aux autres par le biais d'un chemin commun unité de commande-connexion de commande (10),
- une unité de commande (30) permettant la délivrance d'un signal de commande ;
dans lequel chacun des éléments de commutation (120, 220, 320) commandés électriquement présente :

- une première connexion de courant de charge (122, 222, 322) pour l'amenée d'un courant de charge à commuter, une deuxième connexion de courant de charge (124, 224, 324) pour la sortie du courant de charge à commuter et une connexion de commande (126, 226, 326) pour la commande de l'élément de commutation (120, 220, 320) au moyen d'un signal de commande, où les première et deuxième connexions de courant de charge (122, 222, 322, 124, 224, 324) sont intégrées dans un chemin de courant de charge (110, 210, 310) du dispositif de commutation (1) et où la connexion de commande (126, 226, 326) est intégrée dans un chemin de courant de commande (112, 212, 312) du dispositif de commutation (1) ;
- un élément de couplage (140, 240, 340) pour le transfert d'énergie séparé galvaniquement,

dans lequel une première partie de l'élément de couplage (142, 242, 342) présente au moins deux connexions et est connecté en série avec le chemin de courant de charge (110, 210, 310), et

une deuxième partie de l'élément de couplage (144, 244, 344) présente au moins deux connexions, où au moins une des connexions est reliée avec le chemin commun unité de charge-connexion de commande (10), où

au moins une nouvelle connexion de la deuxième partie de l'élément de couplage (144, 244, 344) est reliée avec la connexion de commande (126, 226, 326) de l'élément de commutation (120, 220, 320) respectif commandé électriquement,

dans lequel chacun des éléments de commutation (120, 220, 320) commandés électriquement présente un nouvel élément de couplage,

**caractérisé en ce que**

les deuxièmes parties des éléments de couplage (142, 242, 342) des nouveaux éléments de couplage (150, 250, 350) des éléments de commutation (120, 220, 320) commandés électriquement sont connectées en série,

dans lequel la connexion en série des deuxièmes parties des éléments de couplage (142, 242, 342) des nouveaux éléments de couplage (150, 250, 350) est connectée en série avec le chemin commun unité de commande-connexion de commande (10.

**2.** Dispositif de commutation (1) selon la revendication 1, dans lequel au moins une des connexions de la deuxième partie de l'élément de couplage (142, 242, 342) d'un premier élément de commutation (120, 220, 320) commandé électriquement est reliée avec la connexion de commande (126, 226, 326) d'un nouvel élément de commutation (120, 220, 320) commandé électriquement,

> dans lequel au moins une nouvelle connexion de la deuxième partie de l'élément de couplage (142, 242, 342) du premier élément de commutation (120, 220, 320) commandé électriquement est reliée avec le chemin commun unité de commande-connexion de commande (10), dans lequel au moins une des connexions de la deuxième partie de l'élément de couplage (142, 242, 342) du nouvel élément de commutation (120, 220, 320) commandé électriquement est reliée avec la connexion de commande (126, 226, 326) du premier élément de commutation (120, 220, 320) commandé électriquement, et dans lequel au moins une nouvelle connexion de la deuxième partie de l'élément de couplage (142, 242, 342) du nouvel élément de commutation (120, 220, 320) commandé électriquement est reliée avec le chemin commun unité de commande-connexion de commande (10).

**3.** Dispositif de commutation (1) selon la revendication 1, dans lequel les deuxièmes parties des éléments de couplage (142, 242, 342) des éléments de commutation (120, 220, 320) commandés électriquement sont connectés en série, dans lequel le circuit en série des deuxièmes parties des éléments de couplage (142, 242, 342) est connecté en série avec le chemin commun unité de commande-connexion de commande (10).

**4.** Dispositif de commutation (1) selon l'une des revendications précédentes, dans lequel l'élément de couplage (140, 240, 340, 150, 250, 350) est un transformateur, dans lequel la première partie de l'élément de couplage est une bobine primaire (142, 242, 342 ; 152, 252, 352) du transformateur et la deuxième partie de l'élément de couplage est une bobine secondaire (144, 244, 344 ; 154, 254, 354) du transformateur.

**5.** Dispositif de commutation (1) selon l'une des revendications précédentes, dans lequel l'unité de commande (30) présente au moins une source de tension ou une source de courant (31, 34) et/ou un pilote de grille standard.

**6.** Procédé de distribution homogène de courant et/ou de réduction de pertes de commutation pour des éléments de commutation (120, 220, 320) commandés électriquement, connectés en parallèle, présentant :

> - la mise au point d'éléments de commutation (120, 220, 320) commandés électriquement, connectés en parallèle, où chacun des éléments de commutation (120, 220, 320) commandés électriquement présente :
> - une première connexion de courant de charge (122, 222, 322) pour l'amenée d'un courant de charge à commuter, une deuxième connexion de courant de charge (124, 224, 324) pour la sortie du courant de charge à commuter et une connexion de commande (126, 226, 326) pour la commande de l'élément de commutation (120, 220, 320), où les première et deuxième connexions de courant de charge (124, 224, 324 ; 126, 226, 326) sont intégrées dans un chemin de courant de charge (110, 210, 310) et la connexion de commande (126, 226, 326) est intégrée dans un chemin de courant de commande (112, 212, 312) ;
> - la commande des éléments de commutation (120, 220, 320) commandés électriquement, connectés en parallèle à l'aide d'une unité de commande (30) par le biais d'un chemin commun unité de commande-connexion de commande (10) ;
> - le transfert d'énergie séparé galvaniquement d'énergie à l'aide d'un élément de couplage (140, 240, 340),

>> dans lequel une première partie de l'élément de couplage (142, 242, 342) présente au moins deux connexions et est connectée en série avec le chemin de courant de charge (110, 210, 310), et une deuxième partie de l'élément de couplage (144, 244, 344) présente au moins deux connexions, où au moins une des connexions est reliée avec le chemin commun unité de charge-connexion de commande (10) ;

> - le transfert séparé galvaniquement d'énergie à l'aide des éléments de couplage (140, 240, 340) à partir des chemins de courant de charge (110, 210, 310) vers les chemins de courant de commande (112, 212, 312) de l'élément de commutation (120, 220, 320) commandé électriquement respectif,

>> dans lequel au moins une nouvelle connexion de la deuxième partie de l'élément de couplage (144, 244, 344) est reliée avec la connexion de commande (126, 226, 326) de l'élément de commutation (120, 220, 320) respectif commandé électriquement, dans lequel chacun des éléments de commutation (120, 220, 320) commandés électriquement présente un nouvel élément de couplage ;

le transfert séparé galvaniquement d'énergie à l'aide des nouveaux éléments de couplage (150, 250, 350) à partir des chemins de courant de charge (110, 210, 310) des éléments de commutation (120, 220, 320) commandés électriquement vers le chemin commun unité de commande-connexion de commande (10),

**caractérisé en ce que**

les deuxièmes parties des éléments de couplage (142, 242, 342) des nouveaux éléments de couplage (150, 250, 350) des éléments de commutation (120, 220, 320) commandés électriquement sont connectées en série,

dans lequel la connexion en série des deuxièmes parties des éléments de couplage (142, 242, 342) des nouveaux éléments de couplage (150, 250, 350) est connectée en série avec le chemin commun unité de commande-connexion de commande (10).

**7.** Procédé selon la revendication 6, le procédé présentant en outre :

- le transfert séparé galvaniquement d'énergie à l'aide d'un élément de couplage (140, 240, 340) à partir du chemin de courant de charge (110, 210, 310) vers le chemin de courant de commande (112, 212, 312).

**8.** Procédé selon la revendication 6, dans lequel au moins une des connexions de la deuxième partie de l'élément de couplage (142, 242, 342) d'un premier élément de commutation (120, 220, 320) commandé électriquement est reliée avec la connexion de commande (126, 226, 326) d'un nouvel élément de commutation (120, 220, 320) commandé électriquement,

dans lequel au moins une nouvelle connexion de la deuxième partie de l'élément de couplage (142, 242, 342) du premier élément de commutation (120, 220, 320) commandé électriquement est reliée avec le chemin commun unité de commande-connexion de commande (10), dans lequel au moins une des connexions de la deuxième partie de l'élément de couplage (142, 242, 342) du nouvel élément de commutation (120, 220, 320) commandé électriquement est reliée avec la connexion de commande (126, 226, 326) du premier élément de commande (120, 220, 320) commandé électriquement, dans lequel au moins une nouvelle connexion de la deuxième partie de l'élément de couplage (142, 242, 342) du nouvel élément de commutation (120, 220, 320) commandé électriquement est reliée avec le chemin commun unité de commande-connexion de commande (10), le procédé présentant en outre :

- le transfert séparé galvaniquement d'énergie à l'aide d'un élément de couplage (140, 240, 340) à partir du chemin de courant de charge (110, 210, 310) du premier élément de commutation (120, 220, 320) commandé électriquement vers le chemin de courant de commande (112, 212, 312) du nouvel élément de commutation (120, 220, 320) commandé électriquement,

- le transfert séparé galvaniquement d'énergie à l'aide d'un élément de couplage (140, 240, 340) à partir du chemin de courant de charge (110, 210, 310) du nouvel élément de commutation (120, 220, 320) commandé électriquement vers le chemin de courant de commande (112, 212, 312) du premier élément de commutation (120, 220, 320) commandé électriquement.

**9.** Procédé selon la revendication 6, dans lequel les deuxièmes parties des éléments de couplage (142, 242, 342) des éléments de commutation (120, 220, 320) commandés électriquement sont connectées en série,

dans lequel le circuit en série des deuxièmes parties des éléments de couplage (142, 242, 342) est connecté en série avec le chemin commun unité de commande-connexion de commande (10), le procédé présentant en outre :

- le transfert séparé galvaniquement d'énergie à l'aide des éléments de couplage (150, 250, 350) à partir des chemins de courant de charge (110, 210, 310) des éléments de commutation (120, 220, 320) commandés électriquement vers le chemin commun unité de commande-connexion de commande (10).

Fig. 1

Fig. 2

Fig. 3

Fig. 4

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20160352330 A1
- CA 2986883 A1